# EUROPEAN PATENT APPLICATION

(11) **EP 4 191 678 A1**
(43) Date of publication of application: **07.06.2023**
(21) Application number: 21850834.9
(22) Date of filing: 15.07.2021
(51) Int. Cl.: H01L 27/30, H01L 27/146, H01L 31/10, H01L 51/42

(54) **DETECTION DEVICE**

(30) Priority: 28.07.2020 JP 2020127338
(71) Applicant: Japan Display Inc., Tokyo 105-0003 (JP); The University of Tokyo, Bunkyo-ku, Tokyo 113-8654 (JP)
(72) Inventor: HIMOTO, Kento, Tokyo 105-0003 (JP); NAKAMURA, Takashi, Tokyo 105-0003 (JP); SOMEYA, Takao, Tokyo 113-8654 (JP); YOKOTA, Tomoyuki, Tokyo 113-8654 (JP)
(74) Representative: MERH-IP Matias Erny Reichl Hoffmann Patentanwälte PartG mbB
(86) International application number: PCT/JP2021/026599
(87) International publication number: WO 2022/024781

(57) **Abstract**

A detection device is a detection device including a plurality of optical sensors arranged on a substrate. In each of the optical sensors, a lower electrode, an electron transport layer, an active layer, a hole transport layer, and an upper electrode are stacked in a direction orthogonal to a surface of the substrate in the order as listed. The active layer contains an organic semiconductor. The hole transport layer includes a metal oxide layer and is provided on the active layer so as to be in contact therewith.

## Description

### Field

The present invention relates to a detection device.

### Background

Optical sensors capable of detecting fingerprint patterns and vascular patterns are known (for example, Patent Literature 1). Flexible sheet sensors that use an organic semiconductor material as an active layer are known as such optical sensors.

### Citation List

### Patent Literature

Patent Literature 1: Japanese Patent Application Laid-open Publication No. 2009-032005

### Summary

### Technical Problem

In the optical sensors, electrode peeling may occur due to low adhesion between the active layer made of an organic material and a metal electrode stacked on the active layer.

It is an object of the present invention to provide a detection device capable of restraining the occurrence of the electrode peeling.

### Solution to Problem

According to an aspect of the present invention, a detection device includes a plurality of optical sensors arranged on a substrate. In each of the optical sensors: a lower electrode, an electron transport layer, an active layer, a hole transport layer, and an upper electrode are

stacked in a direction orthogonal to a surface of the substrate in the order as listed; the active layer includes an organic semiconductor; and the hole transport layer includes a metal oxide layer and is provided on the active layer so as to be in contact with the active layer.

### Brief Description of Drawings

FIG. 1 is a plan view illustrating a detection device according to a first embodiment of the present invention.
FIG. 2 is a block diagram illustrating a configuration example of the detection device according to the first embodiment.
FIG. 3 is a circuit diagram illustrating the detection device.
FIG. 4 is a circuit diagram illustrating a plurality of partial detection areas.
FIG. 5 is a sectional view illustrating a schematic sectional configuration of a sensor.
FIG. 6 is a waveform timing chart illustrating an operation example of the detection device.
FIG. 7 is a waveform timing chart illustrating an operation example during a read period in FIG. 6.
FIG. 8 is a graph illustrating a relation between a thickness of an active layer and sensor capacitance.
FIG. 9 is a graph illustrating a relation between the thickness of the active layer and a sensor output voltage.
FIG. 10 is a sectional view illustrating a schematic sectional configuration of a sensor of a detection device according to a second embodiment of the present invention. Description of Embodiments

The following describes modes (embodiments) for carrying out the present invention in detail with reference to the drawings. The present invention is not limited to the description of the embodiments given below. Components described below include those easily conceivable by those skilled in the art or those substantially identical thereto. In addition, the components described below can be combined as appropriate. What is disclosed herein is merely an example, and the present invention naturally encompasses appropriate modifications easily conceivable by those skilled in the art while maintaining the gist of the invention. To further clarify the description, the drawings may schematically illustrate, for example, widths, thicknesses, and shapes of various parts as compared with actual aspects thereof. However, they are merely examples, and interpretation of the present invention is not limited thereto. The same component as that described with reference to an already mentioned drawing is denoted by the same reference numeral through the present specification and the drawings, and detailed description thereof may not be repeated where appropriate.

In the present specification and claims, in expressing an aspect of disposing another structure on or above a certain structure, a case of simply expressing "on" includes both a case of disposing the other structure immediately on the certain structure so as to contact the certain structure and a case of disposing the other structure above the certain structure with still another structure interposed therebetween, unless otherwise specified.

### First Embodiment

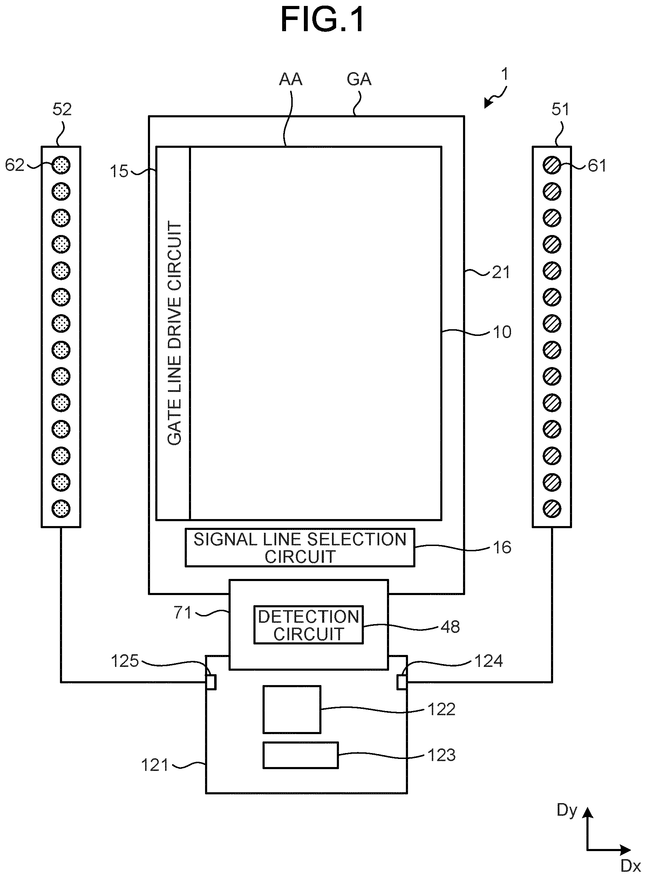

FIG. 1 is a plan view illustrating a detection device according to a first embodiment of the present invention. As illustrated in FIG. 1, a detection device 1 includes a sensor base member 21, a sensor 10, a gate line drive circuit 15, a signal line selection circuit 16, a detection circuit 48, a control circuit 122, a power supply circuit 123, a first light source base member 51, a second light source base member 52, first light sources 61, and second light sources 62. The first light source base member 51 is provided with the first light sources 61. The second light source base member 52 is provided with the second light sources 62.

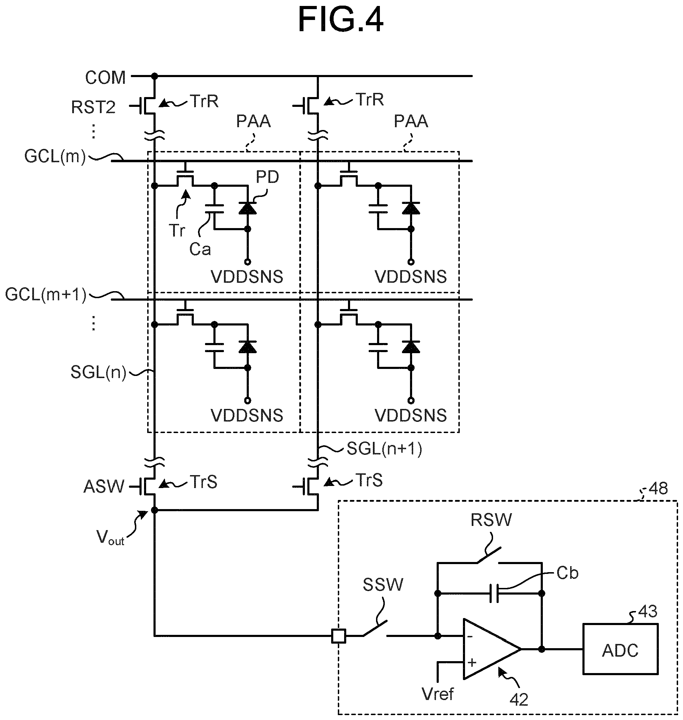

The sensor base member 21 is electrically coupled to a control substrate 121 through a flexible printed circuit board 71. The flexible printed circuit board 71 is provided with the detection circuit 48. The control substrate 121 is provided with the control circuit 122 and the power supply circuit 123. The control circuit 122 is, for example, a field-programmable gate array (FPGA). The control circuit 122 supplies control signals to the sensor 10, the gate line drive circuit 15, and the signal line selection circuit 16 to control a detection operation of the sensor 10. The control circuit 122 supplies control signals to the first and the second light sources 61 and 62 to control lighting and non-lighting of the first and the second light sources 61 and 62. The power supply circuit 123 supplies voltage signals including, for example, a sensor power supply signal VDDSNS (refer to FIG. 4) to the sensor 10, the gate line drive circuit 15, and the signal line selection circuit 16. The power supply circuit 123 supplies a power supply voltage to the first and the second light sources 61 and 62.

The sensor base member 21 has a detection area AA and a peripheral area GA. The detection area AA is an area provided with a plurality of optical sensors PD (refer to FIG. 4) included in the sensor 10. The peripheral area GA is an area between the outer perimeter of the detection area AA and the ends of the sensor base member 21 and is an area not provided with the optical sensors PD.

The gate line drive circuit 15 and the signal line selection circuit 16 are provided in the peripheral area GA. Specifically, the gate line drive circuit 15 is provided in an area extending along a second direction Dy in the peripheral area GA. The signal line selection circuit 16 is provided in an area extending along a first direction Dx in the peripheral area GA, and is provided between the sensor 10 and the detection circuit 48.

The first direction Dx is one direction in a plane parallel to the sensor base member 21. The second direction Dy is one direction in the plane parallel to the sensor base member 21, and is a direction orthogonal to the first direction Dx. The second direction Dy may non-orthogonally intersect the first direction Dx.

The first light sources 61 are provided on the first light source base member 51, and are arranged along the second direction Dy. The second light sources 62 are provided on the second light source base member 52, and are arranged along the second direction Dy. The first light source base member 51 and the second light source base member 52 are electrically coupled, through respective terminals 124 and 125, provided on the control substrate 121, to the control circuit 122 and the power supply circuit 123.

For example, inorganic light-emitting diodes (LEDs) or organic electroluminescent (EL) diodes (organic light-emitting diodes(OLEDs)) are used as the first and the second light sources 61 and 62. The first and the second light sources 61 and 62 emit first light and second light, respectively, having different wavelengths.

The first light emitted from the first light sources 61 is mainly reflected on a surface of an object to be detected, such as a finger Fg, and is incident on the sensor 10. As a result, the sensor 10 can detect a fingerprint by detecting a shape of asperities on the surface of the finger Fg or the like. The second light emitted from the second light sources 62 is mainly reflected in the finger Fg or the like, or transmitted through the finger Fg or the like, and is incident on the sensor 10. As a result, the sensor 10 can detect information on a living body in the finger Fg or the like. Examples of the information on the living body include a pulse wave, pulsation, and a vascular image of the finger Fg or a palm. That is, the detection device 1 may be configured as a fingerprint detection device to detect a fingerprint or a vein detection device to detect a vascular pattern of, for example, veins.

The first light may have a wavelength of from 500 nm to 600 nm, for example, a wavelength of approximately 550 nm, and the second light may have a wavelength of from 780 nm and 950 nm, for example, a wavelength of approximately 850 nm. In this case, the first light is blue or green visible light, and the second light is infrared light. The sensor 10 can detect the fingerprint based on the first light emitted from the first light sources 61. The second light emitted from the second light sources 62 is reflected in the object to be detected such as the finger Fg, or transmitted through or absorbed by the finger Fg or the like, and is incident on the sensor 10. As a result, the sensor 10 can detect the pulse wave or the vascular image (vascular pattern) as the information on the living body in the finger Fg or the like.

Alternatively, the first light may have a wavelength of from 600 nm to 700 nm, for example, approximately 660 nm, and the second light may have a wavelength of from 780 nm and 900 nm, for example, approximately 850 nm. In this case, the sensor 10 can detect a blood oxygen saturation level in addition to the pulse wave, the pulsation, and the vascular image as the information on the living body based on the first light emitted from the first light sources 61 and the second light emitted from the second light sources 62. Thus, the detection device 1 includes the first and the second light sources 61 and 62, and therefore, can detect the various information on the living body by performing the detection based on the first light and the detection based on the second light.

The arrangement of the first and the second light sources 61 and 62 illustrated in FIG. 1 is merely an example, and may be changed as appropriate. The detection device 1 is provided with a plurality of types of light sources (first and second light sources 61 and 62) as the light sources. However, the light sources are not limited thereto, and may be of one type. For example, the first and the second light sources 61 and 62 may be arranged on each of the first and the second light source base members 51 and 52. The first and the second light sources 61 and 62 may be provided on one light source base member, or three or more light source base members. Alternatively, at least one light source needs to be disposed.

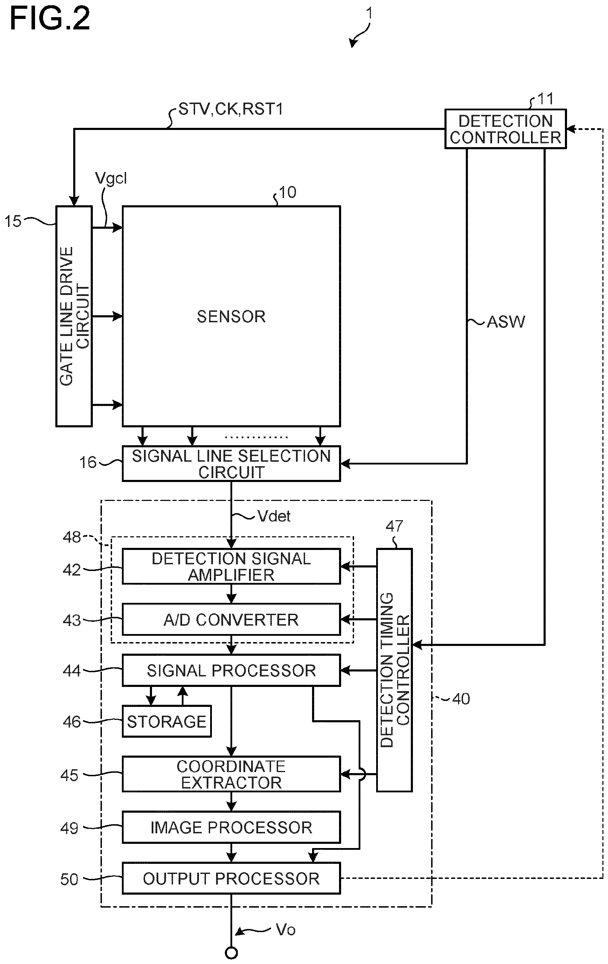

FIG. 2 is a block diagram illustrating a configuration example of the detection device according to the first embodiment. As illustrated in FIG. 2, the detection device 1 further includes a detection controller 11 and a detector 40. The control circuit 122 includes one, some, or all functions of the detection controller 11. The control circuit 122 also includes one, some, or all functions of the detector 40 other than those of the detection circuit 48.

The sensor 10 includes the optical sensors PD. Each of the optical sensors PD included in the sensor 10 is a photodiode, and outputs an electrical signal corresponding to light emitted thereto as a detection signal Vdet to the signal line selection circuit 16. The sensor 10 performs the detection in response to a gate drive signal Vgcl supplied from the gate line drive circuit 15.

The detection controller 11 is a circuit that supplies respective control signals to the gate line drive circuit 15, the signal line selection circuit 16, and the detector 40 to control operations of these components. The detection controller 11 supplies various control signals including, for example, a start signal STV, a clock signal CK, and a reset signal RST1 to the gate line drive circuit 15. The detection controller 11 also supplies various control signals including, for example, a selection signal ASW to the signal line selection circuit 16. The detection controller 11 supplies various control signals to the first and the second light sources 61 and 62 to control the lighting and the non-lighting of each group of the first and the second light sources 61 and 62.

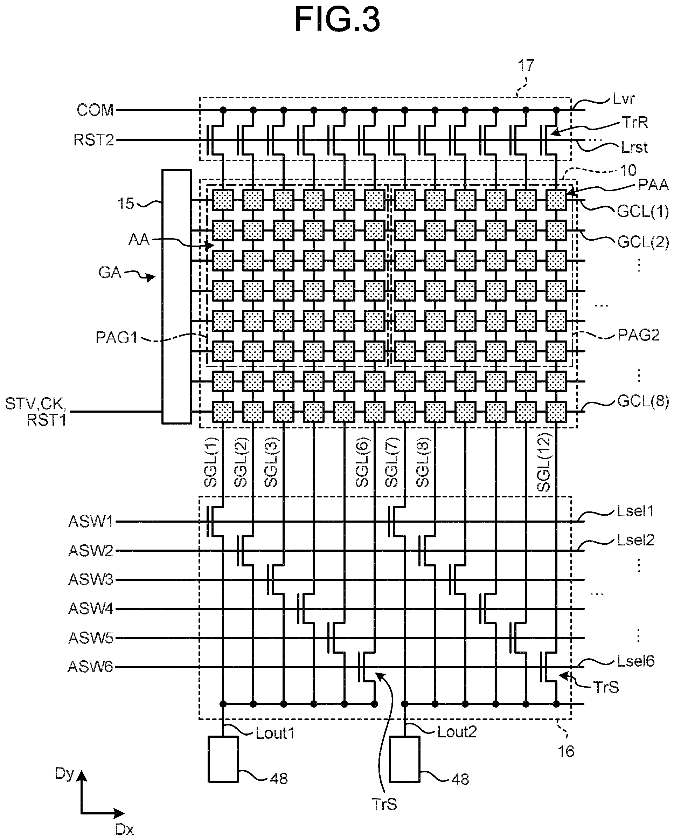

The gate line drive circuit 15 is a circuit that drives a plurality of gate lines GCL (refer to FIG. 3) based on the various control signals. The gate line drive circuit 15 sequentially or simultaneously selects the gate lines GCL, and supplies the gate drive signals Vgcl to the selected gate lines GCL. By this operation, the gate line drive circuit 15 selects the optical sensors PD coupled to the gate lines GCL.

The signal line selection circuit 16 is a switch circuit that sequentially or simultaneously selects a plurality of signal lines SGL (refer to FIG. 3). The signal line selection circuit 16 is, for example, a multiplexer. The signal line selection circuit 16 couples the selected signal lines SGL to the detection circuit 48 based on the selection signal ASW supplied from the detection controller 11. By this operation, the signal line selection circuit 16 outputs the detection signals Vdet of the optical sensors PD to the detector 40.

The detector 40 includes the detection circuit 48, a signal processor 44, a coordinate extractor 45, a storage 46, a detection timing controller 47, an image processor 49, and an output processor 50. Based on a control signal supplied from the detection controller 11, the detection timing controller 47 controls the detection circuit 48, the signal processor 44, the coordinate extractor 45, and the image processor 49 so as to operate in synchronization with one another.

The detection circuit 48 is, for example, an analog front-end (AFE) circuit. The detection circuit 48 is a signal processing circuit having functions of at least a detection signal amplifier 42 and an analog-to-digital (A/D) converter 43. The detection signal amplifier 42 amplifies the detection signals Vdet. The A/D converter 43 converts analog signals output from the detection signal amplifier 42 into digital signals.

The signal processor 44 is a logic circuit that detects a predetermined physical quantity received by the sensor 10 based on an output signal of the detection circuit 48. The signal processor 44 can detect the asperities on the surface of the finger Fg or the palm based on the signals from the detection circuit 48 when the finger Fg is in contact with or in proximity to a detection surface. The signal processor 44 can also detect the information on the living body based on the signals from the detection circuit 48. Examples of the information on the living body include the vascular image, the pulse wave, the pulsation, and the blood oxygen level of the finger Fg or the palm.

The signal processor 44 may also perform processing of acquiring the detection signals Vdet (information on the living body) simultaneously detected by the optical sensors PD, and averaging the detection signals Vdet. In this case, the detector 40 can perform stable detection by reducing measurement errors caused by noise or relative positional misalignment between the object to be detected, such as the Fg finger, and the sensor 10.

The storage 46 temporarily stores therein signals calculated by the signal processor 44. The storage 46 may be, for example, a random-access memory (RAM) or a register circuit.

The coordinate extractor 45 is a logic circuit that obtains detected coordinates of the asperities on the surface of the finger or the like when the contact or the proximity of the finger is detected by the signal processor 44. The coordinate extractor 45 is the logic circuit that also obtains detected coordinates of blood vessels of the finger Fg or the palm. The image processor 49 combines the detection signals Vdet output from the respective optical sensors PD of the sensor 10 to generate two-dimensional information indicating the shape of the asperities on the surface of the finger Fg or the like and two-dimensional information indicating the shape of the blood vessels of the finger Fg or the palm. The coordinate extractor 45 may output the detection signals Vdet as sensor output voltages Vo instead of calculating the detected coordinates. A case can be considered where the detector 40 does not include the coordinate extractor 45 and the image processor 49.

The output processor 50 serves as a processor that performs processing based on the outputs from the optical sensors PD. Specifically, the output processor 50 of the present embodiment outputs the sensor output voltages Vo including at least the pulse wave data based on at least the detection signals Vdet acquired through the signal processor 44. In the present embodiment, the signal processor 44 outputs data indicating a variation (amplitude) in output voltage of the detection signal Vdet of each of the optical sensors PD (to be described later), and the output processor 50 determines which outputs are to be employed as the sensor output voltages Vo. However, the signal processor 44 or the output processor 50 may perform both these operations. The output processor 50 may include, for example, the detected coordinates obtained by the coordinate extractor 45 and the two-dimensional information generated by the image processor 49 in the sensor output voltages Vo. The function of the output processor 50 may be integrated into another component (such as the image processor 49).

The following describes a circuit configuration example of the detection device 1. FIG. 3 is a circuit diagram illustrating the detection device. As illustrated in FIG. 3, the sensor 10 has a plurality of partial detection areas PAA arranged in a matrix having a row-column configuration. Each of the partial detection areas PAA is provided with the optical sensor PD.

The gate lines GCL extend in the first direction Dx, and are each coupled to the partial detection areas PAA arranged in the first direction Dx. A plurality of gate lines GCL(1), GCL(2), ..., GCL(8) are arranged in the second direction Dy, and are each coupled to the gate line drive circuit 15. In the following description, the gate lines GCL(1), GCL(2), ..., GCL(8) will each be simply referred to as the gate line GCL when they need not be distinguished from one another. For ease of understanding of the description, FIG. 3 illustrates eight gate lines GCL. However, this is merely an example, and M gate lines GCL (where M is eight or larger, and is, for example, equal to 256) may be arranged.

The signal lines SGL extend in the second direction Dy, and are each coupled to the optical sensors PD of the partial detection areas PAA arranged in the second direction Dy. A plurality of signal lines SGL(1), SGL(2), ..., SGL(12) are arranged in the first direction Dx, and are each coupled to the signal line selection circuit 16 and a reset circuit 17. In the following description, the signal lines SGL(1), SGL(2), ..., SGL(12) will each be simply referred to as the signal line SGL when they need not be distinguished from one another.

For ease of understanding of the description, 12 of the signal lines SGL are illustrated. However, this is merely an example, and N signal lines SGL (where N is 12 or larger, and is, for example, equal to 252) may be arranged. In FIG. 3, the sensor 10 is provided between the signal line selection circuit 16 and the reset circuit 17. The configuration is not limited thereto. The signal line selection circuit 16 and the reset circuit 17 may be coupled to ends of the signal lines SGL in the same direction. The substantial area of one sensor is, for example, substantially 50×50 µm². The resolution of the detection area AA is, for example, substantially 508 pixels per inch (ppi). The number of the sensors arranged in the detection area AA is, for example, 252 cells × 256 cells. The area of the detection area AA is, for example, 12.6×12.8 mm².

The gate line drive circuit 15 receives the various control signals such as the start signal STV, the clock signal CK, and the reset signal RST1 from the control circuit 122 (refer to FIG. 1). The gate line drive circuit 15 sequentially selects the gate lines GCL(1), GCL(2), ..., GCL(8) in a time-division manner based on the various control signals. The gate line drive circuit 15 supplies the gate drive signal Vgcl to the selected one of the gate lines GCL. This operation supplies the gate drive signal Vgcl to a plurality of first switching elements Tr coupled to the gate line GCL, and corresponding ones of the partial detection areas PAA arranged in the first direction Dx are selected as detection targets.

The gate line drive circuit 15 may perform different driving for each of detection modes including the detection of the fingerprint and the detection of different items of the information on the living body (such as the pulse wave, the pulsation, the blood vessel image, and the blood oxygen level). For example, the gate line drive circuit 15 may drive more than one of the gate lines GCL collectively.

The signal line selection circuit 16 includes a plurality of selection signal lines Lsel, a plurality of output signal lines Lout, and third switching elements TrS. The third switching elements TrS are provided corresponding to the signal lines SGL. Six signal lines SGL(1), SGL(2), ..., SGL(6) are coupled to a common output signal line Lout1. Six signal lines SGL(7), SGL(8), ..., SGL(12) are coupled to a common output signal line Lout2. The output signal lines Lout1 and Lout2 are each coupled to the detection circuit 48.

The signal lines SGL(1), SGL(2), ..., SGL(6) are grouped into a first signal line block, and the signal lines SGL(7), SGL(8), ..., SGL(12) are grouped into a second signal line block. The selection signal lines Lsel are coupled to the gates of the respective third switching elements TrS included in one of the signal line blocks. One of the selection signal lines Lsel is coupled to the gates of the third switching elements TrS in the signal line blocks.

The control circuit 122 (refer to FIG. 1) sequentially supplies the selection signal ASW to the selection signal lines Lsel. This operation causes the signal line selection circuit 16 to operate the third switching elements TrS to sequentially select the signal lines SGL in one of the signal line blocks in a time-division manner. The signal line selection circuit 16 selects one of the signal lines SGL in each of the signal line blocks. With the above-described configuration, the detection device 1 can reduce the number of integrated circuits (ICs) including the detection circuit 48 or the number of terminals of the ICs. The signal line selection circuit 16 may couple more than one of the signal lines SGL collectively to the detection circuit 48.

As illustrated in FIG. 3, the reset circuit 17 includes a reference signal line Lvr, a reset signal line Lrst, and fourth switching elements TrR. The fourth switching elements TrR are provided correspondingly to the signal lines SGL. The reference signal line Lvr is coupled to either the sources or the drains of the fourth switching elements TrR. The reset signal line Lrst is coupled to the gates of the fourth switching elements TrR.

The control circuit 122 supplies a reset signal RST2 to the reset signal line Lrst. This operation turns on the fourth switching elements TrR to electrically couple the signal lines SGL to the reference signal line Lvr. The power supply circuit 123 supplies a reference signal COM to the reference signal line Lvr. This operation supplies the reference signal COM to a capacitive element Ca (refer to FIG. 4) included in each of the partial detection areas PAA.

FIG. 4 is a circuit diagram illustrating the partial detection areas. FIG. 4 also illustrates a circuit configuration of the detection circuit 48. As illustrated in FIG. 4, each of the partial detection areas PAA includes the optical sensor PD, the capacitive element Ca, and a corresponding one of the first switching elements Tr. The capacitive element Ca is a capacitor (sensor capacitance) generated in the optical sensor PD, and is equivalently coupled in parallel with the optical sensor PD.

FIG. 4 illustrates two gate lines GCL(m) and GCL(m+1) arranged in the second direction Dy among the gate lines GCL. FIG. 4 also illustrates two signal lines SGL(n) and SGL(n+1) arranged in the first direction Dx among the signal lines SGL. The partial detection area PAA is an area surrounded by the gate lines GCL and the signal lines SGL.

The first switching elements Tr are provided corresponding to the optical sensors PD. Each of the first switching elements Tr includes a thin-film transistor, and in this example, includes an n-channel metal oxide semiconductor (MOS) thin-film transistor (TFT).

The gates of the first switching elements Tr belonging to the partial detection areas PAA arranged in the first direction Dx are coupled to the gate line GCL. The sources of the first switching elements Tr belonging to the partial detection areas PAA arranged in the second direction Dy are coupled to the signal line SGL. The drain of the first switching element Tr is coupled to the cathode of the optical sensor PD and the capacitive element Ca.

The anode of the optical sensor PD is supplied with the sensor power supply signal VDDSNS from the power supply circuit 123. The signal line SGL and the capacitive element Ca are supplied with the reference signal COM that serves as an initial potential of the signal line SGL and the capacitive element Ca from the power supply circuit 123.

When the partial detection area PAA is irradiated with light, a current corresponding to the amount of the light flows through the optical sensor PD. As a result, an electric charge is stored in the capacitive element Ca. After the first switching element Tr is turned on, a current corresponding to the electric charge stored in the capacitive element Ca flows through the signal line SGL. The signal line SGL is coupled to the detection circuit 48 through a corresponding one of the third switching elements TrS of the signal line selection circuit 16. Thus, the detection device 1 can detect a signal corresponding to the amount of the light received by the optical sensor PD for each of the partial detection areas PAA or for each block unit PAG.

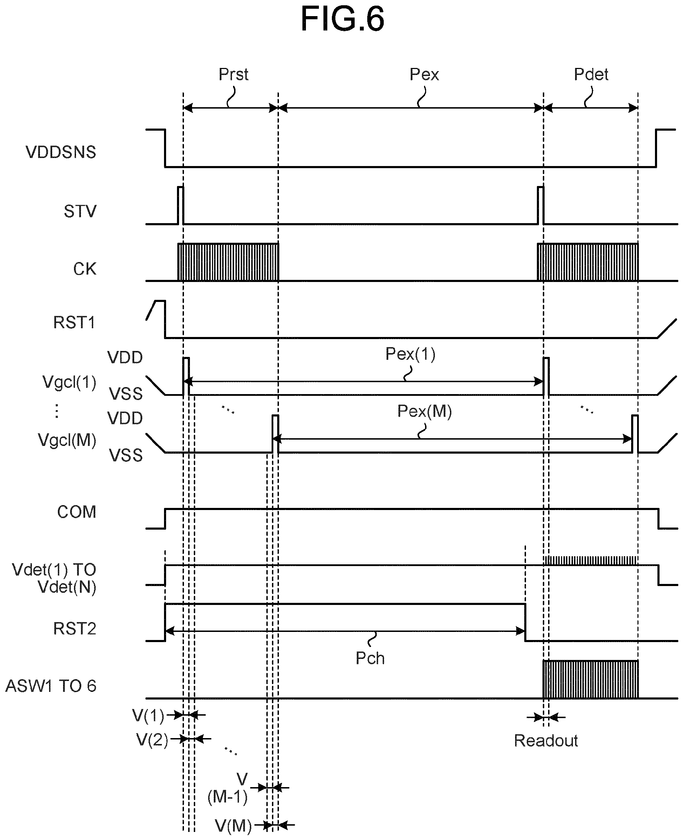

During a read period Pdet (refer to FIG. 6), a switch SSW of the detection circuit 48 is turned on, and the detection circuit 48 is coupled to the signal lines SGL. The detection signal amplifier 42 of the detection circuit 48 converts a variation of a current supplied from the signal lines SGL into a variation of a voltage, and amplifies the result. A reference potential (Vref) having a fixed potential is supplied to a non-inverting input terminal (+) of the detection signal amplifier 42, and the signal lines SGL are coupled to an inverting input terminal (-) of the detection signal amplifier 42. In the present embodiment, the same signal as the reference signal COM is supplied as the reference potential (Vref) voltage. The signal processor 44 (refer to FIG. 2) calculates the difference between the detection signal Vdet when the optical sensor PD is irradiated by light and the detection signal Vdet when the optical sensor PD is not irradiated by light, as each of the sensor output voltages Vo. The detection signal amplifier 42 includes a capacitive element Cb and a reset switch RSW. During a reset period Prst (refer to FIG. 6), the reset switch RSW is turned on, and the electric charge of the capacitive element Cb is reset.

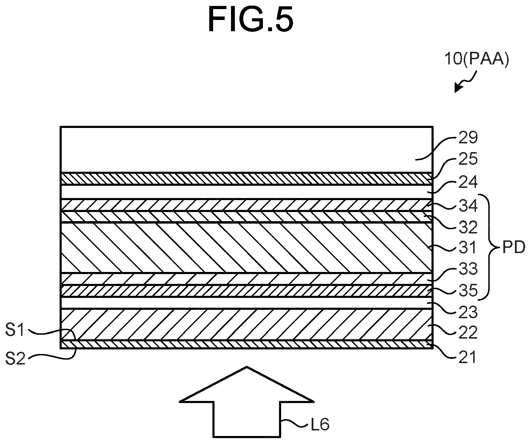

The following describes a configuration of the optical sensor PD. FIG. 5 is a sectional view illustrating a schematic sectional configuration of the sensor. As illustrated in FIG. 5, the sensor 10 includes the sensor base member 21, a TFT layer 22, an insulating layer 23, the optical sensor PD, an intermediate layer 24, a sealing layer 25, and a protective layer 29. The sensor base member 21 is an insulating base member, and is made using, for example, glass or a resin material. The sensor base member 21 is not limited to having a flat plate shape and may have a curved surface. In this case, the sensor base member 21 can be a film-like resin. The sensor base member 21 has a first surface S1 and a second surface S2 on the opposite side to the first surface. The TFT layer 22, the insulating layer 23, the optical sensor PD, the intermediate layer 24, the sealing layer 25, and the protective layer 29 are stacked in this order on the first surface S1. In the present embodiment, a configuration will be described in which light L6 is applied to the optical sensor PD from the second surface S2 side. However, the sensor 10 is not limited to this configuration, and may have a configuration in which the light L6 is applied to the optical sensor PD from the first surface S1 side.

The TFT layer 22 is provided with circuits such as the gate line drive circuit 15 and the signal line selection circuit 16 described above. The TFT layer 22 is also provided with TFTs, such as the first switching elements Tr, and various types of wiring, such as the gate lines GCL and the signal lines SGL. The sensor base member 21 and the TFT layer 22 serve as a drive circuit board that drives the sensor for each predetermined detection area, and are also called a backplane or an array substrate.

The insulating layer 23 is an organic insulating layer and is provided on the TFT layer 22. The insulating layer 23 is a planarizing layer that planarizes asperities formed by the first switching elements Tr and various conductive layers formed in the TFT layer 22.

The optical sensor PD is provided on the insulating layer 23. The optical sensor PD includes a lower electrode 35, an electron transport layer 33, an active layer 31, a hole transport layer 32, and an upper electrode 34, which are stacked in this order in a direction orthogonal to the first surface S1 of the sensor base member 21.

The lower electrode 35 is provided on the insulating layer 23 and is electrically coupled to the first switching element Tr in the TFT layer 22 through a contact hole (not illustrated). The lower electrode 35 is the cathode of the optical sensor PD and is an electrode for reading the detection signal Vdet. The lower electrode 35 is formed of, for example, a light-transmitting conductive material such as indium tin oxide (ITO).

The active layer 31 changes in characteristics (for example, voltage-current characteristics and a resistance value) according to light emitted thereto. An organic material is used as a material of the active layer 31. Specifically, the active layer 31 has a bulk heterostructure in which a p-type organic semiconductor is mixed with an n-type fullerene derivative (PCBM) that is an n-type organic semiconductor. As the active layer 31, low-molecular-weight organic materials can be used including, for example, fullerene (C₆₀), phenyl-C61-butyric acid methyl ester (PCBM), copper phthalocyanine (CuPc), fluorinated copper phthalocyanine (F₁₆CuPc), 5,6,11,12-tetraphenyltetracene (rubrene), and perylene diimide (PDI) (derivative of perylene).

The active layer 31 can be formed by a vapor deposition process (dry process) using any of these low-molecular-weight organic materials. In this case, the active layer 31 may be, for example, a multilayered film of CuPc and F16CuPc, or a multilayered film of rubrene and C₆₀. The active layer 31 can also be formed by a coating process (wet process). In this case, the active layer 31 is made using a material obtained by combining any of the above-listed low-molecular-weight organic materials with a high-molecular-weight organic material. As the high-molecular-weight organic material, for example, poly(3-hexylthiophene) (P3HT) and F8-alt-benzothiadiazole (F8BT) can be used. The active layer 31 can be a film made of a mixture of P3HT and PCBM, or a film made of a mixture of F8BT and PDI.

The upper electrode 34 is the anode of the optical sensor PD and is an electrode for supplying the power supply signal VDDSNS to the photoelectric conversion layers. The upper electrode 34 faces the lower electrode 35 with the active layer 31 interposed therebetween. For example, silver (Ag) is used as the upper electrode 34. Alternatively, the upper electrode 34 may be a metal material such as aluminum (Al) or an alloy material containing at least one or more of these metal materials.

The electron transport layer 33 and the hole transport layer 32 are provided to facilitate holes and electrons generated in the active layer 31 to reach the upper electrode 34 or the lower electrode 35. The electron transport layer 33 is provided between the lower electrode 35 and the active layer 31 in the direction orthogonal to the first surface S1 of the sensor base member 21. The electron transport layer 33 is in direct contact with the top of the lower electrode 35, and the active layer 31 is in direct contact with the top of the electron transport layer 33. Polyethylenimine ethoxylated (PEIE) is used as a material of the electron transport layer 33.

The hole transport layer 32 is provided between the active layer 31 and the upper electrode 34 in the direction orthogonal to the first surface S1 of the sensor base member 21. The hole transport layer 32 is in direct contact with the top of the active layer 31, and the upper electrode 34 is in direct contact with the top of the hole transport layer 32. The hole transport layer 32 is a metal oxide layer. For example, tungsten oxide (WO₃) or molybdenum oxide is used as the oxide metal layer.

In the present embodiment, the hole transport layer 32 formed of tungsten oxide that is a metal oxide is provided between the active layer 31 formed of an organic semiconductor material and the upper electrode 34 formed of a metal material. This configuration can improve the adhesion between the active layer 31 and the upper electrode 34 as compared with a configuration in which the hole transport layer 32 is formed of a polythiophene-based conductive polymer (PEDOT:PSS), for example. This configuration allows the detection device 1 to be configured as a flexible sensor that can restrain the upper electrode 34 from peeling off, and is resistant to bending.

The sealing layer 25 is provided so as to cover the optical sensor PD. More specifically, the sealing layer 25 is provided above the upper electrode 34 with the intermediate layer 24 interposed therebetween. The material of the sealing layer 25 is aluminum oxide (Al₂O₃). This configuration allows the detection device 1 to seal the optical sensor PD better than in a case of using parylene as the sealing layer 25. ITO is used as a material of the intermediate layer 24. The intermediate layer 24 can improve the adhesion between the upper electrode 34 and the sealing layer 25.

The protective layer 29 is provided so as to cover the sealing layer 25. For example, a resin film is used as the protective layer 29. The protective layer 29 is provided to protect the optical sensor PD. The material of the protective layer 29 is not limited to a resin film, and other materials may be used.

In the present embodiment, the configuration has been described in which the light L6 is applied to the optical sensor PD from the second surface S2 side. However, the configuration may be such that the light L6 is applied to the optical sensor PD from the first surface S1 side. In this case, a light-transmitting conductive material such as ITO is used as the upper electrode 34, and a metal material such as silver is used as the lower electrode 35.

The following describes an operation example of the detection device 1. FIG. 6 is a waveform timing chart illustrating the operation example of the detection device. As illustrated in FIG. 6, the detection device 1 has the reset period Prst, an exposure period Pex, and the read period Pdet. The power supply circuit 123 supplies the sensor power supply signal VDDSNS to the anode of the optical sensor PD over the reset period Prst, the exposure period Pex, and the read period Pdet. The sensor power supply signal VDDSNS is a signal that applies a reverse bias between the anode and the cathode of the optical sensor PD. For example, the reference signal COM of substantially 0.75 V is applied to the cathode of the optical sensor PD, and the sensor power supply signal VDDSNS of substantially -1.25 V is applied to the anode thereof. As a result, a reverse bias of substantially 2.0 V is applied between the anode and the cathode. The control circuit 122 sets the reset signal RST2 to "H", and then, supplies the start signal STV and the clock signal CK to the gate line drive circuit 15 to start the reset period Prst. During the reset period Prst, the control circuit 122 supplies the reference signal COM to the reset circuit 17, and uses the reset signal RST2 to turn on the fourth switching elements TrR for supplying a reset voltage. This operation supplies the reference signal COM as the reset voltage to each of the signal lines SGL. The reference signal COM is set to, for example, 0.75 V.

During the reset period Prst, the gate line drive circuit 15 sequentially selects each of the gate lines GCL based on the start signal STV, the clock signal CK, and the reset signal RST1. The gate line drive circuit 15 sequentially supplies the gate drive signals Vgcl {Vgcl(1), ..., Vgcl(M)} to the gate lines GCL. The gate drive signal Vgcl has a pulsed waveform having a power supply voltage VDD serving as a high-level voltage and a power supply voltage VSS serving as a low-level voltage. In FIG. 6, M gate lines GCL (where M is, for example, 256) are provided, and the gate drive signals Vgcl(1), ..., Vgcl(M) are sequentially supplied to the respective gate lines GCL. Thus, the first switching elements Tr are sequentially brought into a conducting state and supplied with the reset voltage on a row-by-row basis. For example, a voltage of 0.75 V of the reference signal COM is supplied as the reset voltage.

Thus, during the reset period Prst, the capacitive elements Ca of all the partial detection areas PAA are sequentially electrically coupled to the signal lines SGL, and are supplied with the reference signal COM. As a result, the capacitance of the capacitive elements Ca is reset. The capacitance of the capacitive elements Ca of some of the partial detection areas PAA can be reset by partially selecting the gate lines and the signal lines SGL.

Examples of the method of controlling the exposure include a method of controlling the exposure during non-selection of the gate lines and a method of always controlling the exposure. In the method of controlling the exposure during non-selection of the gate lines, the gate drive signals {Vgcl(1), ..., Vgcl(M)} are sequentially supplied to all the gate lines GCL coupled to the optical sensors PD serving as the detection targets, and all the optical sensors PD serving as the detection targets are supplied with the reset voltage. Then, after all the gate lines GCL coupled to the optical sensors PD serving as the detection targets are set to a low voltage (the first switching elements Tr are turned off), the exposure starts and the exposure is performed during the exposure period Pex. After the exposure ends, the gate drive signals {Vgcl(1), ..., Vgcl(M)} are sequentially supplied to the gate lines GCL coupled to the optical sensors PD serving as the detection targets as described above, and reading is performed during the read period Pdet. In the method of always controlling the exposure, the control for performing the exposure can also be performed during the reset period Prst and the read period Pdet (the exposure is always controlled). In this case, the exposure period Pex(1) starts after the gate drive signal Vgcl(1) is supplied to the gate line GCL during the reset period Prst. The exposure periods Pex {(1), ..., (M)} are periods during which the capacitive elements Ca are charged from the optical sensors PD. The electric charge stored in the capacitive element Ca during the reset period Prst causes a reverse directional current (from cathode to anode) to flow through the optical sensor PD due to light irradiation, and the potential difference in the capacitive element Ca decreases. The start timing and the end timing of the actual exposure periods Pex(1), ..., Pex(M) are different among the partial detection areas PAA corresponding to the gate lines GCL. Each of the exposure periods Pex(1), ..., Pex(M) starts when the gate drive signal Vgcl changes from the power supply voltage VDD serving as the high-level voltage to the power supply voltage VSS serving as the low-level voltage during the reset period Prst. Each of the exposure periods Pex(1), ..., Pex(M) ends when the gate drive signal Vgcl changes from the power supply voltage VSS to the power supply voltage VDD during the read period Pdet. The lengths of the exposure time of the exposure periods Pex(1), ..., Pex(M) are equal.

In the method of controlling the exposure during non-selection of the gate lines, a current flows depending on the light received by the optical sensor PD in each of the partial detection areas PAA during the exposure periods Pex {(1) ···(M)}. As a result, an electric charge is stored in each of the capacitive elements Ca.

At a time before the read period Pdet starts, the control circuit 122 sets the reset signal RST2 to a low-level voltage. This operation stops the operation of the reset circuit 17. The reset signal may be set to a high-level voltage only during the reset period Prst. During the read period Pdet, the gate line drive circuit 15 sequentially supplies the gate drive signals Vgcl(1) ..., Vgcl(M) to the gate lines GCL in the same manner as during the reset period Prst.

Specifically, the gate line drive circuit 15 supplies the gate drive signal Vgcl(1) at the high-level voltage (power supply voltage VDD) to the gate line GCL(1) during a period V(1). The control circuit 122 sequentially supplies the selection signals ASW1, ..., ASW6 to the signal line selection circuit 16 during a period in which the gate drive signal Vgcl(1) is at the high-level voltage (power supply voltage VDD). This operation sequentially or simultaneously couples the signal lines SGL of the partial detection areas PAA selected by the gate drive signal Vgcl(1) to the detection circuit 48. As a result, the detection signal Vdet for each of the partial detection areas PAA is supplied to the detection circuit 48.

In the same manner, the gate line drive circuit 15 supplies the gate drive signals Vgcl(2), ..., Vgcl(M-1), Vgcl(M) at the high-level voltage to gate lines GCL(2), ..., GCL(M-1), GCL(M) during periods V(2), ..., V(M-1), V(M), respectively. That is, the gate line drive circuit 15 supplies the gate drive signal Vgcl to the gate line GCL during each of the periods V(1), V(2), ..., V(M-1), V(M). The signal line selection circuit 16 sequentially selects each of the signal lines SGL based on the selection signal ASW in each period in which the gate drive signal Vgcl is set to the high-level voltage. The signal line selection circuit 16 sequentially couples each of the signal lines SGL to one detection circuit 48. Thus, the detection device 1 can output the detection signals Vdet of all the partial detection areas PAA to the detection circuit 48 during the read period Pdet.

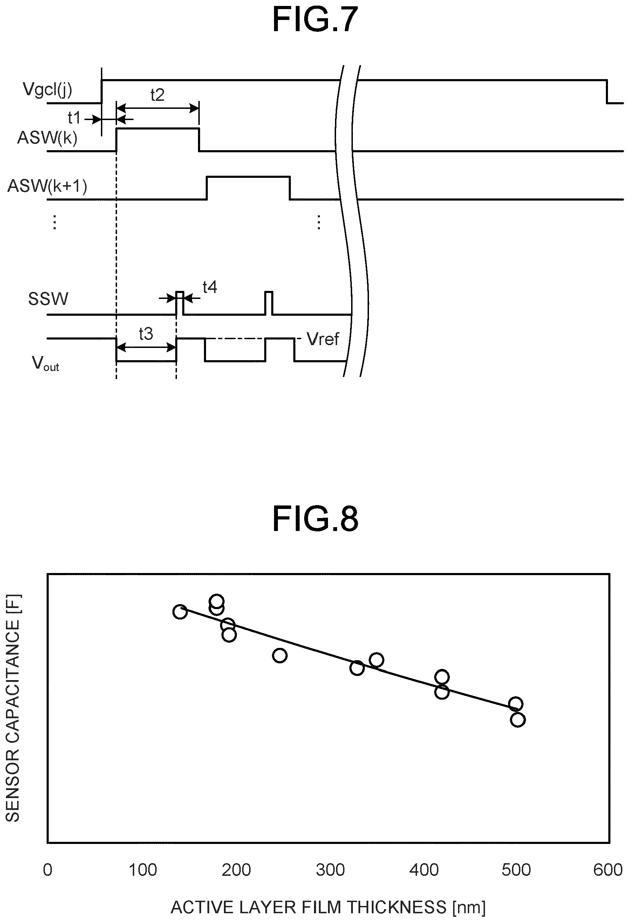

FIG. 7 is a waveform timing chart illustrating an operation example during the read period in FIG. 6. With reference to FIG. 7, the following describes the operation example during a supply period Readout of one of the gate drive signals Vgcl(j) in FIG. 6. In FIG. 6, the reference numeral of the supply period Readout is assigned to the first gate drive signal Vgcl(1), and the same applies to the other gate drive signals Vgcl(2) ..., Vgcl(M). The index j is any one of the natural numbers 1 to M.

As illustrated in FIGS. 7 and 4, an output voltage (Vₒᵤₜ) of each of the third switching elements TrS has been reset to the reference potential (Vref) in advance. The reference potential (Vref) voltage serves as the reset voltage, and is set to, for example, 0.75 V. Then, the gate drive signal Vgcl(j) is set to a high level, and the first switching elements Tr of a corresponding row are turned on. Thus, each of the signal lines SGL in each row is set to a voltage corresponding to the electric charge stored in the capacitor (capacitive element Ca) of the partial detection area PAA. After a period t1 elapses from a rising edge of the gate drive signal Vgcl(j), a period t2 occurs in which the selection signal ASW(k) is set to a high level. After the selection signal ASW(k) is set to the high level and the third switching element TrS is turned on, the electric charge stored in the capacitor (capacitive element Ca) of the partial detection area PAA coupled to the detection circuit 48 through the third switching element TrS changes the output voltage (Vₒᵤₜ) of the third switching element TrS (refer to FIG. 4) to a voltage corresponding to the electric charge stored in the capacitor (capacitive element Ca) of the partial detection area PAA (period t3). In the example of FIG. 7, this voltage is reduced from the reset voltage as illustrated in the period t3. Then, after the switch SSW is turned on (period t4 during which an SSW signal is set to a high level), the electric charge stored in the capacitor (capacitive element Ca) of the partial detection area PAA moves to the capacitor (capacitive element Cb) of the detection signal amplifier 42 of the detection circuit 48, and the output voltage of the detection signal amplifier 42 is set to a voltage corresponding to the electric charge stored in the capacitive element Cb. At this time, the potential of the inverting input portion of the detection signal amplifier 42 is set to an imaginary short-circuit potential of an operational amplifier, and therefore, set to the reference potential (Vref). The A/D converter 43 reads the output voltage of the detection signal amplifier 42. In the example of FIG. 7, waveforms of the selection signals ASW(k), ASW(k+1), ... corresponding to the signal lines SGL of the respective columns are set to a high level to sequentially turn on the third switching elements TrS, and the same operation is sequentially performed to sequentially read the electric charges stored in the capacitors (capacitive elements Ca) of the partial detection areas PAA coupled to the gate line GCL. ASW(k), ASW(k+1), ... in FIG. 7 are, for example, any of ASW1 to ASW6 in FIG. 7.

Specifically, after the period t4 occurs in which the switch SSW is on, the electric charge moves from the capacitor (capacitive element Ca) of the partial detection area PAA to the capacitor (capacitive element Cb) of the detection signal amplifier 42 of the detection circuit 48. At this time, the non-inverting input (+) of the detection signal amplifier 42 is set to the reference potential (Vref) voltage (for example, 0.75 V). As a result, the output voltage (Vₒᵤₜ) of the third switching element TrS is also set to the reference potential (Vref) due to the imaginary short-circuit between the input ends of the detection signal amplifier 42. The voltage of the capacitive element Cb is set to a voltage corresponding to the electric charge stored in the capacitor (capacitive element Ca) of the partial detection area PAA at a location where the third switching element TrS is turned on in response to the selection signal ASW(k). After the output voltage (Vₒᵤₜ) of the third switching element TrS is set to the reference potential (Vref) due to the imaginary short-circuit, the output voltage of the detection signal amplifier 42 reaches a voltage corresponding to the capacitance of the capacitive element Cb, and this output voltage is read by the A/D converter 43. The voltage of the capacitive element Cb is, for example, a voltage between two electrodes provided on a capacitor constituting the capacitive element Cb.

The period t1 is, for example, 20 µs. The period t2 is, for example, 60 µs. The period t3 is, for example, 44.7 µs. The period t4 is, for example, 0.98 µs.

Although FIGS. 6 and 7 illustrate the example in which the gate line drive circuit 15 individually selects the gate line GCL, the present invention is not limited to this example. The gate line drive circuit 15 may simultaneously select a predetermined number (two or more) of the gate lines GCL and sequentially supply the gate drive signals Vgcl to the gate lines GCL in units of the predetermined number of the gate lines GCL. The signal line selection circuit 16 may also simultaneously couple a predetermined number (two or more) of the signal lines SGL to one detection circuit 48. Moreover, the gate line drive circuit 15 may scan some of the gate lines GCL while skipping the others.

The following describes relations between the thickness of the active layer 31 and characteristics of the optical sensor PD. FIG. 8 is a graph illustrating a relation between the thickness of the active layer and the sensor capacitance. The horizontal axis of the graph illustrated in FIG. 8 represents the thickness of the active layer 31, and the vertical axis of the graph represents the sensor capacitance. The sensor capacitance is a capacitance value of the capacitive element Ca (refer to FIG. 4) formed in the optical sensor PD.

As illustrated in FIG. 8, as the thickness of the active layer 31 decreases, the distance between the upper electrode 34 and the lower electrode 35 decreases, and the sensor capacitance increases. As illustrated in FIG. 8, by setting the thickness of the active layer 31 to 500 nm or smaller, the appropriate sensor capacitance can be ensured, and the electric charge corresponding to the light received by the optical sensor PD can be stored in each of the capacitance elements Ca during the exposure period Pex. In other words, although a current flows to the optical sensor PD during the exposure period Pex, the electric charge stored in the capacitor by the current (photocurrent) flowing from the capacitor to the optical sensor PD is quickly released if the capacitance is small; however, by setting the thickness of the active layer 31 to 500 nm or smaller, the detection device 1 can restrain the detection accuracy from decreasing due to the quick release of the electric charge. In addition, the influence of the photocurrent after the end of the exposure is smaller as the capacitance is larger.

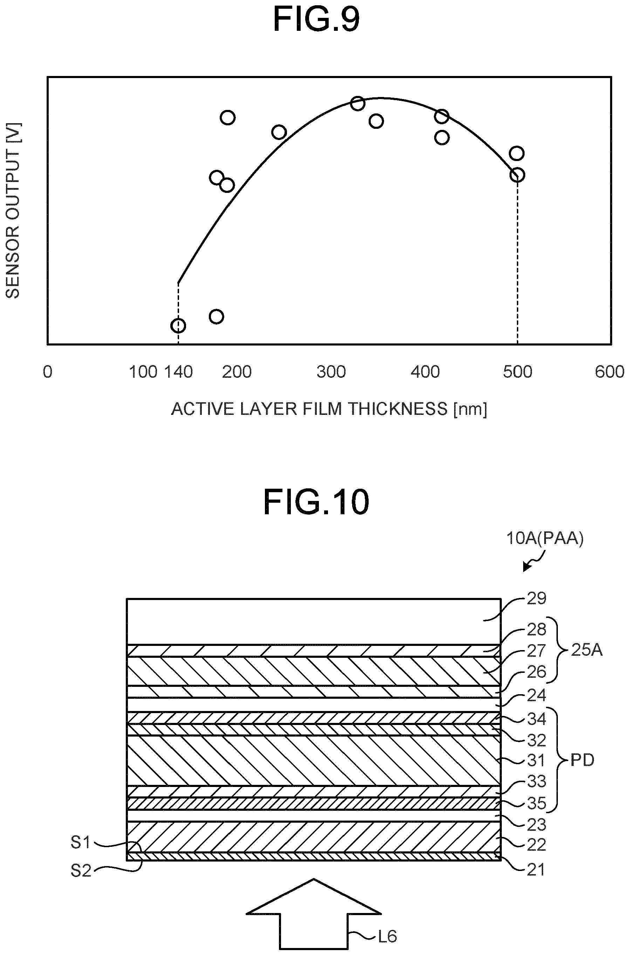

FIG. 9 is a graph illustrating a relation between the thickness of the active layer and the sensor output voltage. The horizontal axis of the graph illustrated in FIG. 9 represents the thickness of the active layer 31, and the vertical axis of the graph represents the sensor output voltage. The sensor output voltage is the output voltage (Vₒᵤₜ) of the third switching element TrS illustrated in FIG. 4.

As illustrated in FIG. 9, the optical sensor PD can ensure the sensor output voltage when the thickness of the active layer 31 is in a range from 140 nm to 500 nm. More specifically, the sensor output voltage reaches a maximum value when the thickness of the active layer 31 is approximately 350 nm. As the thickness of the active layer 31 decreases from 500 nm, the sensor capacitance increases as described above, and as a result, the sensor output voltage also increases. In contrast, as the thickness of the active layer 31 decreases from approximately 350 nm, the leakage current of the optical sensor PD itself increases, and therefore, a larger amount of the electric charge stored in the sensor capacitance leaks, resulting in a smaller sensor output voltage. When the thickness of the active layer 31 is smaller than 140 nm, the efficient sensor output voltage is difficult to be obtained.

As described above, the thickness of the active layer 31 is 500 nm or smaller, more preferably from 140 nm to 500 nm. As a result, the detection device 1 can reduce the photocurrent of the optical sensor PD while maintaining the sensor capacitance, and can well obtain the sensor output voltage.

As described above, the detection device 1 of the present embodiment is a detection device including the optical sensors PD arranged on the substrate (sensor base member 21). In each of the optical sensors PD, the lower electrode 35, the electron transport layer 33, the active layer 31, the hole transport layer 32, and the upper electrode 34 are stacked in the direction orthogonal to the surface of the substrate in the order as listed. The active layer 31 contains an organic semiconductor. The hole transport layer 32 contains tungsten oxide and is provided on the active layer 31 so as to be in contact therewith.

The upper electrode 34 contains silver, and the active layer 31 contains a p-type organic semiconductor and an n-type fullerene derivative that is an n-type organic semiconductor. The sealing layer 25 contains aluminum oxide, and the electron transport layer 33 contains polyethylenimine ethoxylated (PEIE).

With this configuration, since the hole transport layer 32 is formed of tungsten oxide that is an inorganic material, the adhesion between the active layer 31 and the upper electrode 34 can be improved. This configuration allows the detection device 1 to be configured as a flexible sensor that can restrain the upper electrode 34 from peeling off, and is resistant to bending.

### Second Embodiment

FIG. 10 is a sectional view illustrating a schematic sectional configuration of a sensor of a detection device according to a second embodiment of the present invention. In the following description, the same components as those described in the embodiment described above are denoted by the same reference numerals, and the description thereof will not be repeated.

As illustrated in FIG. 10, in a sensor 10A of the second embodiment, the stacking order of the lower electrode 35, the electron transport layer 33, the active layer 31, the hole transport layer 32, and the upper electrode 34 of the optical sensor PD is the same as that in the first embodiment. In the second embodiment, however, the electron transport layer 33 is formed containing zinc oxide (ZnO). As a result, the second embodiment can improve the adhesion between the lower electrode 35 and the active layer 31 as compared with the first embodiment.

A sealing layer 25A is configured by stacking inorganic films 26 and 28 and an organic film 27. The inorganic film 26, the organic film 27, and the inorganic film 28 are stacked in the direction orthogonal to the sensor base member 21 in the order as listed. The inorganic films 26 and 28 are inorganic insulating films of, for example, silicon nitride (SiN). The organic film 27 is, for example, a resin material. In the present embodiment, the sealing layer 25A is multi-layered to enable good sealing of the optical sensor PD.

The configuration of the second embodiment can be combined with that of the first embodiment described above. For example, the sealing layer 25A of the second embodiment may be provided instead of the sealing layer 25 illustrated in FIG. 5 in the sensor 10 of the first embodiment. Alternatively, the electron transport layer 33 formed of zinc oxide (ZnO) may be provided instead of the electron transport layer 33 formed of PEIE in the sensor 10 of the first embodiment.

While the preferred embodiments of the present invention have been described above, the present invention is not limited to the embodiments described above. The content disclosed in the embodiments is merely an example, and can be variously modified within the scope not departing from the gist of the present invention. Any modifications appropriately made within the scope not departing from the gist of the present invention also naturally belong to the technical scope of the present invention. At least one of various omissions, substitutions, and changes of the components can be made without departing from the gist of the embodiments and the modifications described above.

### Reference Signs List

- 1: Detection device
- 10, 10A: Sensor
- 11: Detection controller
- 15: Gate line drive circuit
- 16: Signal line selection circuit
- 21: Sensor base member
- 25, 25A: Sealing layer
- 31: Active layer
- 32: Hole transport layer
- 33: Electron transport layer
- 34: Upper electrode
- 35: Lower electrode
- 40: Detector
- 48: Detection circuit
- AA: Detection area
- GA: Peripheral area
- PD: Optical sensor

## Claims

1. A detection device comprising a plurality of optical sensors arranged on a substrate, wherein
in each of the optical sensors:
a lower electrode, an electron transport layer, an active layer, a hole transport layer, and an upper electrode are stacked in a direction orthogonal to a surface of the substrate in the order as listed;
the active layer includes an organic semiconductor; and
the hole transport layer includes a metal oxide layer and is provided on the active layer so as to be in contact with the active layer.

2. The detection device according to claim 1, wherein the upper electrode contains silver, and
the active layer contains a p-type organic semiconductor and an n-type fullerene derivative that is an n-type organic semiconductor.

3. The detection device according to claim 1 or 2, wherein a thickness of the active layer is 500 nm or smaller.

4. The detection device according to claim 3, wherein the thickness of the active layer is from 140 nm to 500 nm.

5. The detection device according to any one of claims 1 to 4, further comprising a sealing layer covering the optical sensor, wherein
the sealing layer contains aluminum oxide, and
the electron transport layer contains polyethylenimine ethoxylated (PEIE).

6. The detection device according to any one of claims 1 to 4, further comprising a sealing layer covering the optical sensor, wherein
the sealing layer is configured by stacking an inorganic film and an organic film, and
the electron transport layer contains zinc oxide.

7. The detection device according to any one of claims 1 to 6, wherein the metal oxide layer is made of molybdenum oxide or tungsten oxide.
